Europäisches Patentamt

European Patent Office

Office européen des brevets

(11) Publication number: **0 483 741 A2**

# EUROPEAN PATENT APPLICATION

(21) Application number: **91118380.4**

(22) Date of filing: **29.10.91**

(51) Int. Cl.5: **H01L 39/24**, H01L 39/22

(30) Priority: **29.10.90 US 605955**

(43) Date of publication of application:
**06.05.92 Bulletin 92/19**

(84) Designated Contracting States:
**AT BE CH DE DK ES FR GB GR IT LI LU NL SE**

(71) Applicant: **BIOMAGNETIC TECHNOLOGIES, INC.**
**9727 Pacific Heights Blvd.**
**San Diego, CA 92121(US)**

(72) Inventor: **Marsden, James R.**
**11429 Nawa Way**
**San Diego, CA 92129(US)**

(74) Representative: **Dreiss, Uwe, Dr. jur. Dipl.-Ing. M.Sc.**
**Patentanwälte Dreiss, Hosenthien & Fuhlendorf Gerokstrasse 6**
**W-7000 Stuttgart 1(DE)**

(54) **SOUID utilizing polymeric insulation.**

(57) A superconducting quantum interference device (SQUID) (10) is made with a Josephson junction (14) extending between two layers of superconducting material (22, 32). An insulation layer (34) placed between the superconducting layers (22, 32), in the regions displaced from the Josephson junction (14), is made of a polymeric insulation material such as a polyimide. The insulation material may also be used between other metal layers on the same device, such as a planar coil (42) and resistors (36). The insulation material is preferably applied by a spin-on technique.

FIG. 2

# BACKGROUND OF THE INVENTION

This invention relates to the structure of a superconducting quantum interference device, and, more particularly, to such a device having a polymeric insulation layer between superconducting layers.

A Superconducting QUantum Interference Device (known by the acronym of SQUID) includes a loop of superconducting material with one or two Josephson junctions in the loop. SQUIDs are highly sensitive current detectors that are used in several branches of science where very small currents must be measured. In one important application of SQUIDs, a current flowing in a magnetic flux detector coil is sensed, thereby permitting the measurement of very small magnetic fields that pass through the coil. Such detector systems lie at the heart of biomagnetometers used to measure very small magnetic fields produced by the human body. These measurements provide significant information for both an understanding of fundamental functions of the body such as thought processes and also for diagnosing ailments of the body.

A Josephson junction is most readily fabricated by microelectronic techniques, and it has been common practice for a number of years to fabricate the entire SQUID by microelectronic material deposition and removal procedures. Examples of such procedures and the resulting SQUIDs are found in US Patent 4,386,361.

There is a continuing effort to improve the yield of usable SQUIDs produced by microelectronic techniques, and also to improve the performance of the SQUIDs themselves. As with all devices prepared by microelectronic techniques, only a fraction of the SQUIDs fabricated are operable, because of a variety of problems such as internal electrical shorts and incomplete connections. In other cases, the SQUIDs may be physically operable, but may have less-than-optimal performance due to internal capacitances that cause resonances in the SQUIDs when they are used.

Since it is not practical to repair such problems after fabrication is complete, the conventional practice is to fabricate more potentially operable SQUIDs than will be required, fully test the SQUIDs that have been produced before they are placed into instruments, and discard the inoperable or marginally operable SQUIDs. The yield of acceptable SQUIDs is often quite low, sometimes on the order of 10 percent or less. That is, 10 percent or less of the SQUIDs fabricated have acceptable performance. This low yield raises the cost of the SQUIDs. Moreover, in some instances it simply may not be possible to fabricate fully acceptable SQUIDs, and marginally operable SQUIDs having, for example, excessive internal capacitance may have to be used in the final products.

Thus, while the operation of SQUIDs is understood and they are widely used, the fabrication of thin-film SQUIDs on a production scale has remained something of an art practiced on an educated trial-and-error basis. There is an ongoing need for SQUID constructions and fabrication procedures that improve the yield and performance of SQUIDs, particularly where large numbers of similar SQUIDs must be available for apparatus requirements. The present invention fulfills this need, and further provides related advantages.

# SUMMARY OF THE INVENTION

The present invention provides a modified SQUID construction which improves both the manufacturing yield and the operating performance of the SQUID. The approach of the invention utilizes established thin-film manufacturing techniques and materials, in a manner not previously practiced for the manufacture of SQUIDs. The cost of manufacturing each SQUID is substantially the same as for the prior approach, but the cost per usable SQUID is reduced. Moreover, the best performance that can be obtained with the present SQUIDs exceeds those of prior constructions.

In accordance with the invention, a thin film superconducting quantum interference device comprises a first layer of a material that becomes superconducting below its critical temperature; a second layer of a material that becomes superconducting below its critical temperature; a layer of insulative polymer material between the first layer and the second layer; and at least one Josephson junction extending between the first layer and the second layer. Preferably, the device contains two Josephson junctions extending between the first layer and the second layer, and there is a gap in the first layer such that there is no conducting loop in the first layer connecting the two Josephson junctions. Such a circuit with a single Josephson junction is used to make an rf SQUID, and a circuit with two Josephson junctions is used to make a dc SQUID.

SQUIDs used in many applications are packaged with two coils, a modulation coil and an input coil, coupled magnetically to the inductance of the SQUID loop. For all thin film planar designs, these coils are on layers coplanar to the SQUID structure, separated from the SQUID structure by an insulating layer. The resulting capacitance between the coil layers, particularly the input coil which often has many turns, also creates resonances that degrade SQUID performance. The present invention thus provides for a polymeric insulation layer to separate the coil layers from the SQUID loop.

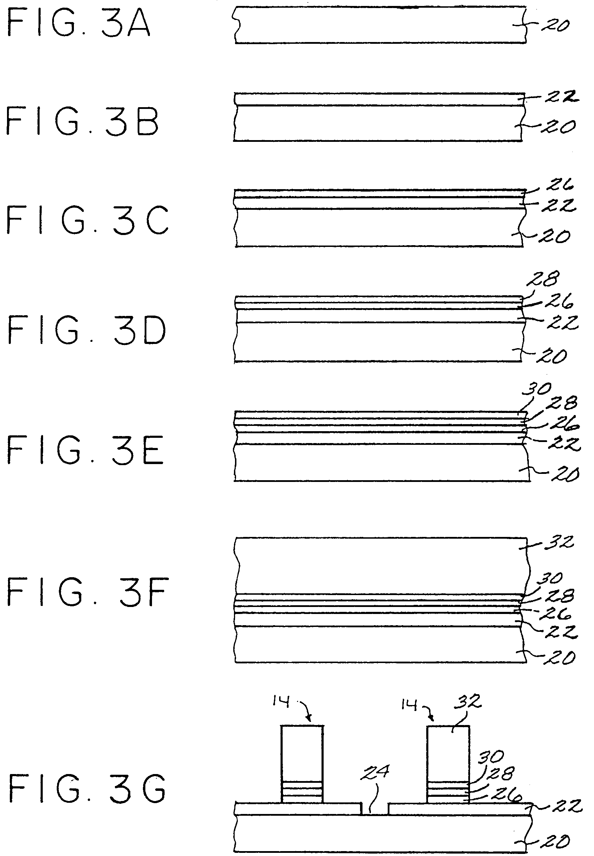

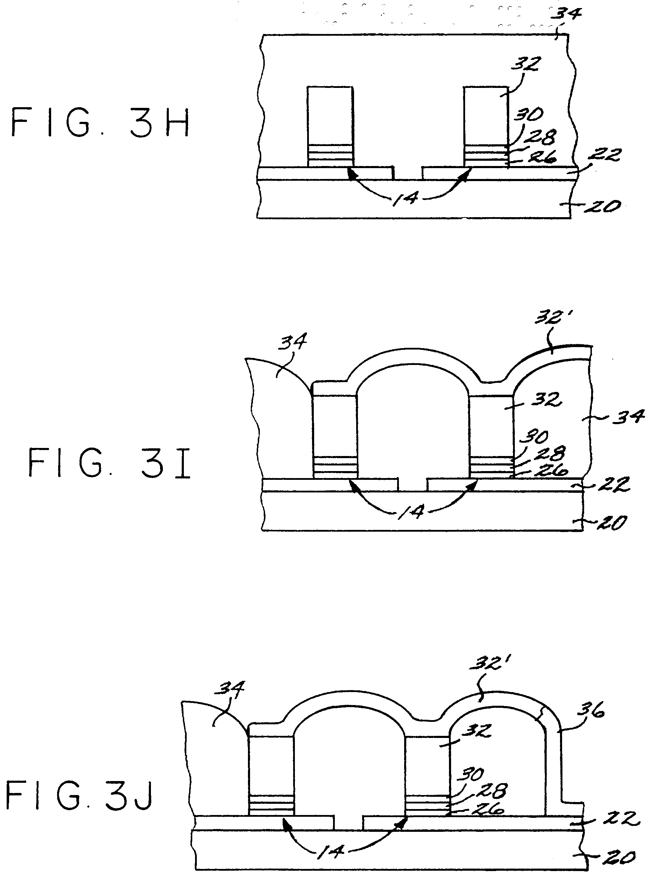

In prior practice, the insulative layer between the first and second layers of superconducting material, and between these layers and the coil layers, has been an amorphous insulator such as silicon oxide or silicon dioxide. See for example Figure 3 of US Patent 4,403,189. The dielectric constant of such insulators is typically about 4-4.5 and the thickness of the insulator layer is about 2000-3000 Angstroms, resulting in a high capacitance between the superconductors and resonance within the SQUID during operation. Moreover, the deposition and etching of such insulators required in the fabrication of the SQUIDs is not as controllable as is desirable. A common problem in SQUIDs fabricated with such insulative layers is undercutting of the insulation during etching, which leads to an open circuit in the finished SQUID. The high capacitance and fabrication problems such as the undercutting can make the SQUID inoperable, and in any event the high capacitance of even an operable SQUID reduces its performance.

The polymeric insulative material of the invention, preferably a polyimide, typically has a dielectric constant of about 2.5. The insulative layer can be made about 2500-10,000 Angstroms (0.25-1.0 micrometers) thick, reducing the capacitive coupling between the superconducting layers. The polymer layer of this thickness has a planarizing effect that improves the deposition of subsequent layers thereon. The polymer layer exhibits well controlled etching and material removal behavior with smoothly sloped sides that seldom exhibit undercutting. As a result, the electronic performance of the SQUID is improved, and the production yield of satisfactory SQUIDs is increased.

Other features and advantages of the invention will be apparent from the following more detailed description of the preferred embodiment, taken in conjunction with the accompanying drawings, which illustrate, by way of example, the principles of the invention.

BRIEF DESCRIPTION OF THE DRAWINGS

Figure 1 is a schematic circuit diagram of a dc SQUID;
Figure 2 is a side elevational view of the finished dc SQUID;
Figure 3 is a pictorial flow diagram for a procedure for fabricating a thin-film SQUID by the approach of the invention, showing the structure of the device at each step of fabrication in views 3A-3J; and

Figure 4 is a side elevational view of a dc SQUID, as in Figure 2, with a coplanar coil layer and intermediate insulation.

DETAILED DESCRIPTION OF THE PREFERRED EMBODIMENT

In accordance with a preferred embodiment of the invention, a device comprises a Josephson junction having a first layer of a material that becomes superconducting below its critical temperature, the first layer continuing beyond the lateral extent of the Josephson junction, a second layer of a material that becomes superconducting below its critical temperature, the second layer continuing laterally beyond the extent of the Josephson junction, and an insulating layer between the first layer and the second layer; and a layer of a polymer insulating material between those portions of the first layer and the second layer that continue laterally beyond the extent of the Josephson junction. The insulating layer between the first layer and the second layer is typically quite thin, and forms the tunneling barrier of the junction.

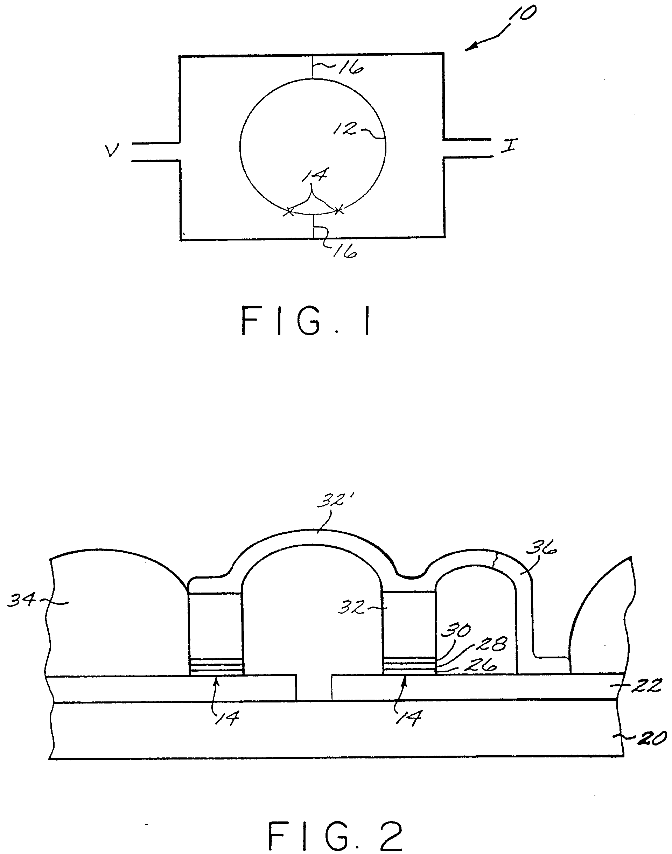

Figure 1 diagrammatically depicts a dc SQUID 10 using the conventional notation. The dc SQUID 10 includes a superconducting current path 12 with two Josephson junctions 14 therein. Signals and biasing are provided by leads 16. Further details of one mode of operation of the dc SQUID 10 may be found in US Patent 4,389,612, and further details of SQUID operation are found in US Patent 4,403,189, whose disclosures are incorporated by reference.

Figure 2 illustrates a preferred embodiment of the thin film dc SQUID of the invention, and Figure 3 depicts a preferred process for preparing such a dc SQUID.

The preparation of the dc SQUID 10 begins with the furnishing of a deposition substrate 20, Figure 3A, which is usually silicon but may be any of a variety of operable substrates. The substrate 20 receives the SQUID structure thereupon, but does not contribute to the electronic operation of the SQUID. The substrate 20 is carefully cleaned with solvents such as acetone and/or methanol to remove dirt, dust, and hydrocarbons that may be present. It is then preferably sputter etched prior to deposition of the active components, followed immediately by deposition of the active components in the same vacuum system to avoid contamination.

A first layer 22 of a material that is superconducting below its critical temperature is then deposited upon the substrate 20, Figure 3B. The preferred material for the layer 22 is niobium, which is a superconductor at temperatures below about 9.2 K. The niobium layer is normally applied by sputtering, and is preferably about 2500 Angstroms thick. Although high temperature superconductors may be used in some instances, in the preferred approach used to fabricate dc SQUIDs of the highest sensitivity, conventional low critical temperature (Tc) superconductors are used, because the SQUID is operated in a liquid helium environment at 4.2 K or less to minimize electronic noise.

A layer 26 of aluminum is deposited overlying the first layer 22 of niobium, Figure 3C. The aluminum layer 26 is preferably from about 60 to about 80 Angstroms thick, and is applied by sputtering.

The aluminum layer 26 is oxidized to form an insulating layer 28 by admitting oxygen to the sputtering chamber at a pressure of about 1 Torr, while the substrate and previously deposited layers are heated to a temperature of about 160 C, see Figure 3D. The thickness of the aluminum oxide layer 28 is a matter of choice for the SQUID system designer, as the electronic performance of the dc SQUID 10 is strongly influenced by the thickness of the layer 28. Typically, however, the insulating layer 28 is about 20 Angstroms thick. (It will be apparent that the various layers in the drawings of Figs. 2 and 3 are not drawn to scale.) The precise composition of the layer 28 is determined by the described oxidation process, and for this preferred embodiment the composition may be indicated simply as $Al_2O_x$.

Another layer 30 of aluminum is deposited overlying the insulating layer 28, preferably by sputtering and preferably in a thickness of about 20 Angstroms, see Figure 3E.

A second layer 32 of superconductor material, preferably niobium, is deposited overlying the aluminum layer 30, see Figure 3F. The second layer 32 of niobium is preferably sputtered, to a thickness of about 2500 Angstroms. The structure of Figure 3F is known in the industry as a "trilayer" structure, referring to the first and second layers 22 and 32, and the insulating layer 28.

The structure of Figure 3F is patterned and etched by conventional photolithographic processes to form the current path 12. A photosensitive mask material is placed over the second layer 32, a pattern is exposed into the mask, and the mask is developed to remove portions of the mask. Then the portions of the structure of Figure 3F that underlie the removed portions of the mask are etched away to produce a pattern like that of Figure 1 when viewed in plan view. In the preferred approach, the photosensitive mask material is any of the commonly available commercial positive photoresists, and the etchants used to remove the underlying structure are carbon tetrafluoride plasma for niobium and phosphoric acid for aluminum. Such patterning procedures are well known in the industry. The resulting structure is depicted by Figure 3G, where the upward projections separated by a gap 24 will form the Josephson junctions 14.

A very thick insulative layer 34 is next applied, Figure 3H. The layer 34 is a polymer such as a polyimide dissolved in a solvent, available from DuPont Corp. as PI-2555. It is preferably applied as a spin-on insulation. The structure shown in Figure 3G is placed on a turntable and rotated at about 5000 revolutions per minute. A small quantity, typically about 2 cubic centimeters, of the solution containing the polyimide is placed on top of the structure. The layer 34 is distributed over the surface of the structure, and the excess solution is spun away. The procedure for applying such spin-on polymeric layers is known, but heretofore has not been utilized in the fabrication of SQUIDs as disclosed herein.

The layer 34 is so thick, preferably between 2500 and 10,000 Angstroms and most preferably about 7500 Angstroms, that the Josephson junction structures 14 are disposed entirely beneath its flat upper surface as shown in Figure 3H. The layer 34 thus becomes a planarizing layer that permits uniform deposition upon and patterning of its upper surface.

The insulative layer 34 is patterned by a photosensitive masking technique like that described previously to permit access to the remaining portions of the second layer 32. Then the second layer 32 is thickened by the addition of more material 32', which is preferably the same material as previously deposited to form the second layer 32, in a thickness of about 2500 Angstroms. The additional material layer 32' connects the remaining layers 32 to form a series current path through the two Josephson junctions 14. The layer 32' can be patterned with a photoresist technique, as described previously, to produce a required pattern. The resulting structure is shown in Figure 3I.

During the post-patterning polymerization, the insulative layer 34 is cured by admitting an inert gas such as argon into a previously evacuated chamber at a pressure of about 1/2 pound per square inch, absolute (psia) and heating the structure to a temperature of about 300°C for a period of about 180 minutes. The polyimide is cured in place, but the niobium and other materials of the SQUIDs 10 are not subjected to undesired nitridation or oxidation.

In most dc SQUID structures, it is desirable to place a resistor between the first layer 22 and the second layer 32. A resistor is readily added by applying a photoresist to the top of the layer 32', patterning the photoresist by conventional techniques, etching a via down to the layer 22, and depositing a resistor layer 36 of about 200 Angstroms thickness of palladium into the via, as shown in Figure 3J.

The structure of Figures 3J and 2 is the final structure of the SQUID 10. External leads are attached to form the circuit shown in Figure 1.

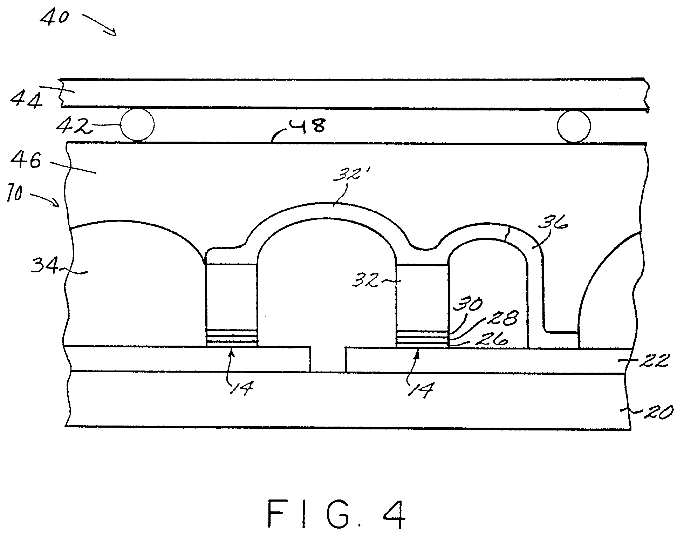

The SQUID 10 is typically used in a device 40, such as a magnetic field detector. A coil 42 supported on a coil support 44 provides the input signal to the SQUID 10. In one approach for making such a device 40, illustrated in Figure 4, after the completion of the process of Figure 3 a further layer 46 of the polymer insulation material is applied over the SQUID 10 by the same techniques, such as the previously described spin-on technique, used to apply the polymer insulation layer 34. The layer 46 may be of any thickness, but is usually at least 5,000-10,000 Angstroms in thickness to produce a planar upper surface 48. (In Figure 4, the polymer layer 34 and the polymer layer 46 are shown as separate layers for illustrative purposes. In effect, the two layers 34 and 46 become a single layer of polymer that are applied at different stages in the fabrication process.) The coil 42 mounted on its support 44 is then inverted with the coil 42 facing downwardly and placed onto the upper surface 48 of the layer 46. The layer 46 replaces other types of insulation previously used, and achieves the advantages discussed elsewhere herein.

Thus, in accordance with this aspect of the invention, a device comprises a planar thin film superconducting quantum interference device; a coil coplanar with the superconducting quantum interference device; and a layer of polymer insulating material between the superconducting quantum interference device and the coil. The SQUID is preferably made by the techniques discussed previously herein.

The use of a polymeric insulative layer 34 has several advantages. First, it has a substantially lower dielectric constant than typical insulators such as silicon oxide and silicon dioxide. Second, it can be made quite thick, thereby separating the layers 22 and 32 (and 32') to reduce capacitance effects. Third, it is readily patterned to produce the patterns shown in Figures 3I and 3J, without undercutting that can lead to open circuits and thence an inoperable SQUID.

Although particular embodiments of the invention have been described in detail for purposes of illustration, various modifications may be made without departing from the spirit and scope of the invention, Accordingly, the invention is not to be limited except as by the appended claims.

**Claims**

1. A device, comprising:
   a first layer of a material that becomes superconducting below its critical temperature;
   a second layer of a material that becomes superconducting below its critical temperature;
   a layer of insulative polymer material between the first layer and the second layer; and
   at least one Josephson junction extending between the first layer and the second layer.

2. The device of claim 1, wherein two Josephson junctions extend between the first layer and the second layer.

3. The device of claim 1, wherein at least one of the first layer and the second layer is niobium.

4. The device of claim 1, wherein the thickness of the first layer and the second layer are each about 2500 Angstroms.

5. The device of claim 1, wherein each Josephson junction contains an aluminum oxide barrier.

6. The device of claim 1, wherein the layer of insulative polymer material is from about 2500 to about 10000 Angstroms thick.

7. The device of claim 1, wherein the insulative polymer material is a polyimide.

8. The device of claim 1, further including
   a coil that is substantially coplanar with the second layer of material that becomes superconducting, and
   a second layer of polymer insulating material between the second layer of material that becomes superconducting, on the one hand, and the coil on the other hand.

9. A device, comprising:
   a Josephson junction having
   a first layer of a material that becomes superconducting below its critical temperature, the first layer continuing beyond the lateral extent of the Josephson junction,
   a second layer of a material that becomes superconducting below its critical temperature, the second layer continuing laterally beyond the extent of the Josephson junction, and
   an insulating layer between the first layer and the second layer; and
   a layer of a polymer insulating material between those portions of the first layer and the second layer that continue laterally beyond the extent of the Josephson junction.

10. A device, comprising:

a thin film planar superconducting quantum interference device;

a coil coplanar with the superconducting quantum interference device; and

a layer of polymer insulating material between the superconducting quantum interference device and the coil.

FIG. 1

FIG. 2

FIG. 3A

FIG. 3B

FIG. 3C

FIG. 3D

FIG. 3E

FIG. 3F

FIG. 3G

FIG. 3H

FIG. 3I

FIG. 3J

FIG. 4